# EUROPÄISCHE PATENTSCHRIFT

(11) **EP 3 378 143 B1**
(45) Veröffentlichungstag und Bekanntmachung des Hinweises auf die Patenterteilung: **20.04.2022**
(21) Anmeldenummer: 16795291.0
(22) Anmeldetag: 10.11.2016
(51) Int. Cl.: H02K 5/15, H02K 5/22

(54) **GEHÄUSEDECKEL FÜR EINE ELEKTRISCHE MASCHINE**
HOUSING COVER FOR AN ELECTRIC MACHINE
COUVERCLE DE BOÎTIER POUR MACHINE ÉLECTRIQUE

(30) Priorität: 16.11.2015 AT 509762015
(43) Veröffentlichungstag der Anmeldung: 26.09.2018
(73) Patentinhaber: MELECS EWS GmbH, 7011 Siegendorf (AT)
(72) Erfinder: GIRCZ, Patrick, 2464 Göttlesbrunn (AT); HELLINGER, Leopold, 3710 Ziersdorf (AT); NEUMANN, Gerhard, 3231 St. Margarethen (AT); NEUMANN, Philipp, 1200 Wien (AT)
(74) Vertreter: Maier, Daniel Oliver
(86) Internationale Anmeldenummer: PCT/EP2016/077198
(87) Internationale Veröffentlichungsnummer: WO 2017/084949

(56) Entgegenhaltungen:
- WO-A1-88/07285
- DE-A1- 10 319 187
- DE-A1-102005 021 726
- JP-A- H0 823 666
- US-A- 4 593 163
- US-A- 5 327 064
- US-A1- 2015 076 934

## Beschreibung

Die Erfindung bezieht sich auf einen Gehäusedeckel für eine elektrische Maschine mit einem Gehäuse, bei dem der Gehäusedeckel eine äußere Hülle aus thermoplastischem Werkstoff umfasst,
bei dem ein innerer Kern aus duroplastischem Werkstoff vorgesehen ist,
bei dem in dem inneren Kern eine elektrische Schaltungsanordnung eingebettet ist, welche über ein elektrisches Verbindungselement verbindbar ist, und bei dem der Gehäusedeckel derartig geformt ist, dass mit ihm eine stirnseitige Öffnung des Gehäuses der elektrischen Maschine dicht verschließbar ist.

Insbesondere in der Fahrzeugelektronik besteht häufig die Notwendigkeit, Geräte mit Steuerelektronik in einen Motor, in ein Getriebe oder in eine Pumpe etc. zu integrieren, um begrenzte Einbauräume möglichst gut zu nutzen und um Leitungswege kurz zu halten.

Dem Stand der Technik entsprechend sind Geräte mit Schaltungselektronik über Kabeln mit elektrischen Maschinen verbunden.

Dieser Ansatz besitzt in seiner bekannten Form die nachteilige Eigenschaft, dass die Anordnung schlecht gegenüber mechanischen Umgebungseinflüssen sowie Alterung geschützt ist. Insbesondere bei Anwendungen in der Fahrzeugtechnik sind Maschinen und Steuerelektronik oft an einer Unter- bzw. Außenseite eines Fahrzeugs angeordnet und deshalb Einflüssen wie Steinschlag, Einwirkung von Feuchtigkeit, Wasser sowie von aggressiven Substanzen etc. ausgesetzt.

Außerdem erfordert die Verbindung von Geräten über Kabel aufwendige Maßnahmen der Schirmung, um die entsprechenden Vorgaben bezüglich der Elektromagnetischen Verträglichkeit, z.B. nach der Europäischen Norm 61800-3, zu erfüllen.

Aus dem Stand der Technik ist die EP 0 972 318 B1 bekannt, in der eine elektrische Verbindungsanordnung beschrieben wird. Ein Leiterbahnträger wird darin durch ein mit Öl gefülltes Gehäuse geführt. Auf dem Leiterbahnträger ist ein ölbeständiger Dichtring angeordnet, der den Leiterbahnträger gegenüber einer Gehäusewand abdichtet.

Dieser Ansatz besitzt die Nachteile, dass der Leiterbahnträger eine Schnittstelle für die Aufnahme des ölbeständigen Dichtrings benötigt und dass die elektrische Verbindungsanordnung nicht vollständig gekapselt und daher Umgebungseinflüssen ausgesetzt ist.

Ferner ist die DE 10 2014 203 466 bekannt. Darin ist ein Gehäuse einer Fluidenergiemaschine angegeben, wobei ein Gehäusedeckel mit einer integrierten Dichtung, die drei Elemente umfasst, beschrieben wird. In den Gehäusedeckel sind zwei Dichtungen integriert und in einem Gehäusemantel ist eine Dichtung angeordnet.

Dieser Ansatz besitzt die nachteilige Eigenschaft einer aus mehreren Teilen bestehenden und daher aufwendigen Dichtungsanordnung.

Weiterhin beschreibt die US 2015/0076934 A1 einen Motor für ein Gebläse, bei welchem eine Trägerplatte in eine Gehäuseausnehmung eingelegt und mit dem Gehäuse verbunden ist.

Die DE 10 2005 021 726 A1 zeigt ein Modul für einen Elektromotor mit Leiterbahnen und elektrischen Bauelementen sowie mit Aufnahmemitteln für einen Sensor.

In der JP H08 23666 A ist ein bürstenloser Motor mit einem Gehäuse offenbart, wobei eine ausgeformte Halterung vorgesehen ist, in welcher ein Hallelement gelagert ist.

Weiterhin ist die WO 88/07285 A1 bekannt, in welcher ein bürstenloser Gleichstrommotor beschrieben ist. Ein geformter Stützkörper ist als Trägerplatte und zugleich als Lagergehäuse für eine Rotorwelle des Gleichstrommotors ausgebildet.

Die DE 10 2010 063 874 A1 beschreibt ein Getriebegehäuse eines Achsgetriebes sowie einen Gehäusedeckel für ein Getriebegehäuse. In den Gehäusedeckel ist eine als Labyrinthdichtung mit mehreren Kammern ausgeführte Dichtung integriert.

Dieser Ansatz besitzt die nachteilige Eigenschaft einer geometrisch aufwendigen Dichtungsanordnung.

Der Erfindung liegt daher die Aufgabe zugrunde, einen gegenüber dem Stand der Technik verbesserten Gehäusedeckel anzugeben.

Erfindungsgemäß wird diese Aufgabe gelöst mit einem Gehäusedeckel der eingangs genannten Art, bei dem auf einer Stirnseite des inneren Kerns ein Lagersitz ausgebildet ist.

Die thermoplastische, äußere Hülle ergibt den Vorteil einer hohen Resistenz gegenüber mechanischen Belastungen sowie gegenüber der Einwirkung von Feuchtigkeit, Wasser und von aggressiven Substanzen.

Der innere Kern aus duroplastischem Werkstoff bewirkt aufgrund der gut einstellbaren thermischen Leitfähigkeit des Duroplastes eine vorteilhafte Abführung von Wärme.

Ferner ist die elektrische Schaltungsanordnung aufgrund ihrer Einbettung in den inneren Kern gut vor Umgebungseinflüssen geschützt. Aufgrund der Ummantelung der elektrischen Schaltungsanordnung durch den inneren Kern muss kein Dichtungselement auf der Schaltungsanordnung angeordnet werden.

Außerdem ergibt sich aus der Einbettung der Schaltungsanordnung in den inneren, duroplastischen Kern der Vorteil eines direkten Anschlusses der Schaltungsanordnung an das in dem Gehäusedeckel ausgebildete, elektrische Verbindungselement. Aufgrund dieser vorteilhaften Eigenschaft kann auf Kabel, die zur Erfüllung der Vorgaben im Hinblick auf die Elektromagnetische Verträglichkeit aufwendig abgeschirmt werden müssten, verzichtet werden.

Weiterhin bildet der innere, duroplastische Kern eine vorteilhafte, molekulare und somit dichte Verbindung mit Komponenten der elektrischen Schaltungsanordnung bzw. einem Gehäuse der elektrischen Maschine sowie der äußeren Hülle aus. Auf eine geometrisch aufwendige bzw. aus mehreren Teilen bestehende Dichtung zwischen dem Gehäusedeckel, dem Gehäuse und der Umgebung kann verzichtet werden.

Duroplast bietet zur Ausbildung des Lagersitzes auf dem inneren Kern aufgrund seiner geringen Schrumpfung und seiner kleinen Fertigungstoleranzen gute Eigenschaften. Durch diese Maßnahme kann eine Welle der elektrischen Maschine unmittelbar in dem Gehäusedeckel gelagert werden.

Eine vorteilhafte Lösung wird erzielt, wenn die elektrische Maschine als ein elektrischer Motor ausgeführt ist und eine Welle des elektrischen Motors in dem Lagersitz gelagert ist. Diese Maßnahme stellt eine vorteilhafte Anwendung des erfindungsgemäßen Gehäusedeckels auf elektrische Motoren dar.

Günstig ist es, wenn der elektrische Motor als ein Aktuatormotor für eine Allrad-Getriebeanordnung ausgeführt ist.

Eine vorteilhafte Ausgestaltung erhält man, wenn die elektrische Maschine als eine Pumpe ausgeführt ist und eine Pumpenwelle in dem Lagersitz gelagert ist.

Günstig ist es, wenn auf dem Gehäusedeckel zumindest eine Montageeinrichtung ausgebildet ist, über die der Gehäusedeckel mit der elektrischen Maschine verstemmt ist. Durch diese Maßnahme ergibt sich eine unmittelbare und daher vorteilhafte Verbindung zwischen dem Gehäusedeckel und der elektrischen Maschine. Auf Kabel zwischen dem Gehäusedeckel und der elektrischen Maschine kann verzichtet werden.

Eine vorteilhafte Ausgestaltung erhält man, wenn der Gehäusedeckel mit der elektrischen Maschine verschraubt ist. Auch durch diese Maßnahme ergibt sich eine unmittelbare und daher vorteilhafte Verbindung zwischen dem Gehäusedeckel und der elektrischen Maschine. Auf Kabel zwischen dem Gehäusedeckel und der elektrischen Maschine kann verzichtet werden.

Eine günstige Lösung ergibt sich, wenn der Gehäusedeckel über einen Feder-Klick-Verschluss mit der elektrischen Maschine verbunden ist.

Auch durch diese Maßnahme ergibt sich eine unmittelbare und daher vorteilhafte Verbindung zwischen dem Gehäusedeckel und der elektrischen Maschine. Auf Kabel zwischen dem Gehäusedeckel und der elektrischen Maschine kann verzichtet werden.

Nachfolgend wird die Erfindung anhand von Ausführungsbeispielen näher erläutert.

Es zeigen beispielhaft:
- Fig. 1:: Einen Schnitt durch die Längsachse eines erfindungsgemäßen Gehäusedeckels und einer elektrischen Maschine in Explosionsdarstellung,
- Fig. 2:: Einen Schnitt durch die Längsachse eines erfindungsgemäßen Gehäusedeckels und einer elektrischen Maschine in gefügter Ausführung,
- Fig. 3:: Einen Schnitt durch die Längsachse einer erfindungsgemäßen äußeren Hülle aus Thermoplast mit einer darauf angeordneten elektrischen Schaltungsanordnung, und
- Fig. 4:: Einen Schnitt durch die Längsachse eines erfindungsgemäßen inneren Kerns aus Duroplast.

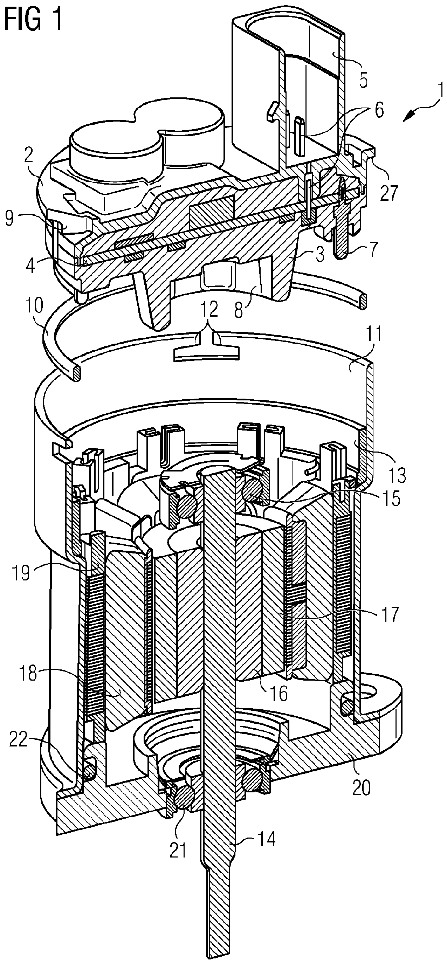

Fig. 1 zeigt eine Ausführungsvariante eines erfindungsgemäßen Gehäusedeckels 1 und einer elektrischen Maschine in Explosionsdarstellung. Die Maschine ist in dieser Variante als ein Aktuatormotor 23 für eine Allrad-Getriebeanordnung ausgeführt. Es sind weitere Varianten elektrischer Maschinen mit dem erfindungsgemäßen Gehäusedeckel 1 kombinierbar, wie z.B. elektrische Motoren im Allgemeinen, Ölpumpen oder Wasserpumpen etc.

Der erfindungsgemäße Gehäusedeckel 1 ist in dem gezeigten Ausführungsbeispiel von zylindrischer Form und umfasst eine zylindrische äußere Hülle 2 aus thermoplastischem Werkstoff und einen mit der äußeren Hülle 2 stirnseitig verbundenen, zylindrischen inneren Kern 3 aus duroplastischem Werkstoff. In den inneren Kern 3 ist eine zylindrische elektrische Schaltungsanordnung 4 eingebettet. Auf der elektrischen Schaltungsanordnung 4 sind in den Aktuatormotor 23 ragende Kontaktierungselemente 7 stirnseitig in Umfangsrichtung angeordnet, die mit einer Wicklung 18 des Aktuatormotors 23 verbunden sind.

Weiterhin ist auf der elektrischen Schaltungsanordnung 4 stirnseitig ein elektrisches Verbindungselement 6 angeordnet, das in einen, auf der äußeren Hülle 2 angeordneten Anschlussbereich 5 ragt. Das elektrische Verbindungselement 6 ist als Stecker ausgeführt. Alternativ ist beispielsweise auch eine Ausführung als eingespritztes Kabel möglich.

Auf der Außenfläche der äußeren Hülle 2 sind mantelseitig in Umfangsrichtung Montageeinrichtungen 9 angeordnet, mit welchen Montagezähne 12, die auf dem Mantel eines zylindrischen, metallischen Gehäuses 11 des Aktuatormotors 23 in Umfangsrichtung ausgebildet sind, verstemmt werden und so eine form- und kraftschlüssige Verbindung zwischen dem Gehäusedeckel 1 und dem Gehäuse 11 ergeben.

Daraus ergibt sich der Vorteil einer unmittelbaren Verbindung zwischen der in den Gehäusedeckel 1 eingebetteten, elektrischen Schaltungsanordnung 4 und dem Aktuatormotor 23, die einen Verzicht auf Kabel ermöglicht. Der zur Herstellung der äußeren Hülle 2 verwendete thermoplastische Werkstoff ist gut fügbar und kann daher gut mit dem Gehäuse 11 verstemmt werden.

Der Gehäusedeckel 1 ist in das Gehäuse 11 eingefügt. Er stützt sich über eine in Umfangsrichtung verlaufende, auf der äußeren Hülle 2 angeordnete Schulter 27 auf dem Gehäuse 11 ab. Der innere Kern 3 ragt in das Innere des Gehäuses 11 und grenzt mit seiner zylindermantelförmigen Außenkontur an die zylindermantelförmige Innenkontur des Gehäuses 11. Zwischen der Innenkontur des Gehäuses 11 und der Außenkontur des inneren Kerns 3 des Gehäusedeckels 1 ist ein zylindrischer B-Dichtring 10 angeordnet. Er liegt auf einem zylindrischen Gehäuseeinsatz 13, der mit seiner mantelseitigen Außenkontur an die Innenkontur des Gehäuses 11 grenzt, auf.

Auf einer Stirnseite des inneren Kerns 3 ist ein Lagersitz 8 ausgebildet. In dem Lagersitz 8 kann ein Rotationssensor, welcher von einem stirnseitig an einer Welle 14 angebrachten Magnet Drehzahlinformationen abgreift, angeordnet werden.

Der für die Herstellung des inneren Kerns 3 verwendete, duroplastische Werkstoff bietet hierzu aufgrund seiner geringen Schrumpfung und seiner kleinen Fertigungstoleranzen gute Eigenschaften.

Der Lagersitz 8 ragt in das Gehäuse 11 des Aktuatormotors 23 und seine Längsachse deckt sich mit der Längsachse des Aktuatormotors 23. In dem Lagersitz 8 ist ein als Kugellager ausgeführtes B-Lager 15 angeordnet, in dem die Welle 14 gelagert ist. Koaxial mit der Welle 14 sind folgende zylindrische Elemente in folgender Reihenfolge eines zunehmenden Radius angeordnet: Rotorbleche 16, ein Rotormagnet 17, die Wicklung 18 und ein Isolationskörper 19. Der Isolationskörper 19 grenzt mit seiner mantelseitigen Außenkontur an die mantelseitige Innenkontur des Gehäuses 11 bzw. des Gehäuseeinsatzes 13.

Auf der dem Gehäusedeckel 1 gegenüberliegenden Stirnseite des Gehäuses ist ein zylindrisches A-Lagerschild 20 und ein als Kugellager ausgeführtes A-Lager 21 angeordnet. In dem A-Lager 21 ist die Welle 14 des Aktuatormotors 23 gelagert. Das A-Lagerschild 20 weist eine in Umfangsrichtung verlaufende Ausnehmung 28 auf, in der ein A-Dichtring 22 angeordnet ist. Das A-Lagerschild 20 grenzt mit seiner mantelseitigen Außenkontur an die mantelseitige Innenkontur des Gehäuses 11. Der A-Dichtring 22 grenzt ebenfalls an die mantelseitige Innenkontur des Gehäuses 11.

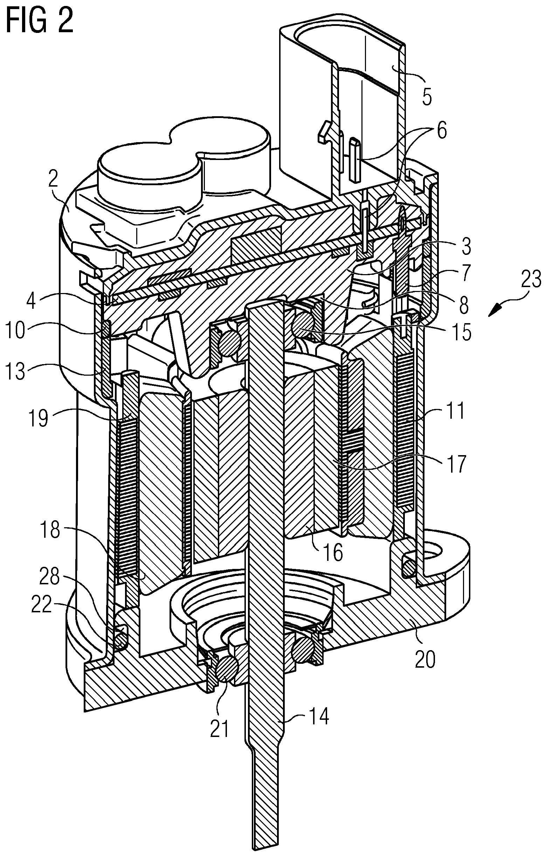

Fig. 2 zeigt eine gefügte Darstellung des erfindungsgemäßen Gehäusedeckels 1 und des Aktuatormotors 23. Es werden die gleichen Bezugszeichen wie in Fig. 1 verwendet.

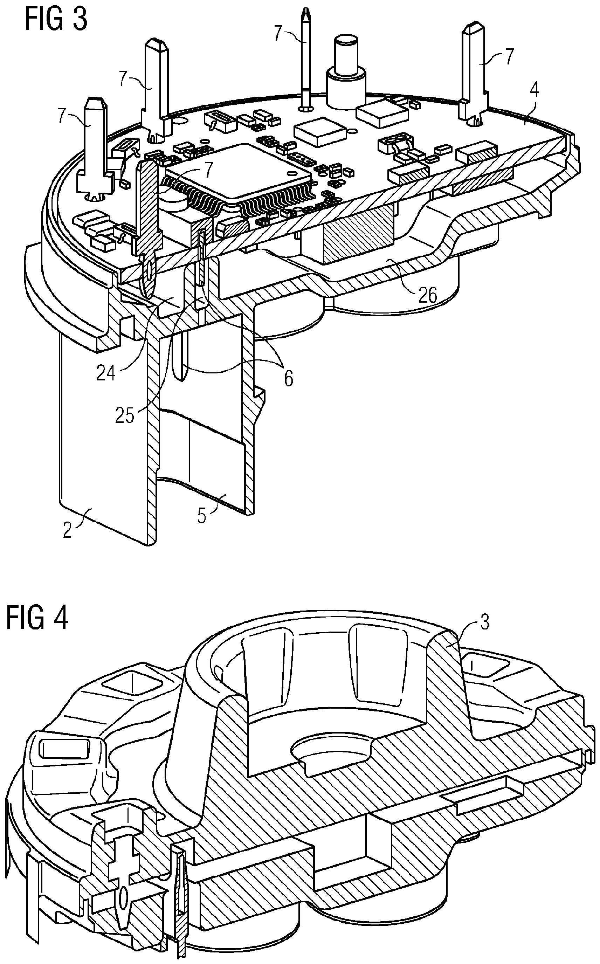

Fig. 3 zeigt die äußere Hülle 2 des erfindungsgemäßen Gehäusedeckels 1 und die darauf angeordnete, elektrische Schaltungsanordnung 4. Zwischen der elektrischen Schaltungsanordnung 4 und der äußeren Hülle 2 befinden sich ein erster Hohlraum 24, ein zweiter Hohlraum 25 und ein dritter Hohlraum 26.

Im Zuge des Herstellprozesses des Gehäusedeckels 1 wird die in Fig. 3 gezeigte Anordnung in ein Duroplast-Werkzeug eingelegt und die elektrische Schaltungsanordnung 4 wird mit Duroplast umspritzt. Im Zuge dieses Vorgangs werden der erste Hohlraum 24, der zweite Hohlraum 25 und der dritte Hohlraum 26 verschlossen und es ergibt sich der innere Kern 3 des Gehäusedeckels 1.

Der sich als Ergebnis des Herstellprozesses ergebende Verbund aus dem inneren Kern 3 aus Duroplast, der Schaltungsanordnung 4 und der äußeren Hülle 2 aus Thermoplast ist in Fig. 1 und Fig. 2 dargestellt.

Die äußere Hülle 2 ergibt den Vorteil einer guten Resistenz gegenüber mechanischen Belastungen auf den für gewöhnlich im Außenbereich von Fahrzeugen angeordneten Gehäusedeckel 1.

Der innere Kern 3 ummantelt und schützt die elektrische Schaltungsanordnung 4.

Duroplast weist eine gute Wärmeleitfähigkeit auf.

Daraus ergibt sich der Vorteil einer guten Wärmeabführung über den inneren Kern 3.

Weiterhin ergibt sich zwischen dem inneren Kern 3 aus Duroplast, dem elektrischen Verbindungselement 6 und dem Kontaktierungselement 7 eine molekulare und somit dichte Verbindung. Eine molekulare und somit dichte Verbindung wird weiterhin auch zwischen der äußeren Hülle 2 und dem inneren Kern 3 erzielt.

Es wird dadurch der Vorteil erzielt, dass auf eine aufwendige Dichtung verzichtet werden kann.

Fig. 4 zeigt den sich als Ergebnis des Herstellprozesses ergebenden inneren Kern 3 des Gehäusedeckels 1 ohne die elektrische Schaltungsanordnung 4.

### Liste der Bezeichnungen

- 1: Gehäusedeckel
- 2: Äußere Hülle
- 3: Innerer Kern
- 4: Elektrische Schaltungsanordnung
- 5: Anschlussbereich
- 6: Elektrisches Verbindungselement
- 7: Kontaktierungselement
- 8: Lagersitz
- 9: Montageeinrichtung
- 10: B-Dichtring
- 11: Gehäuse
- 12: Montagezähne
- 13: Gehäuseeinsatz
- 14: Welle
- 15: B-Lager
- 16: Rotorbleche
- 17: Rotormagnet
- 18: Wicklung
- 19: Isolationskörper
- 20: A-Lagerschild
- 21: A-Lager
- 22: A-Dichtring
- 23: Aktuatormotor
- 24: Erster Hohlraum
- 25: Zweiter Hohlraum
- 26: Dritter Hohlraum
- 27: Schulter
- 28: Ausnehmung

## Patentansprüche

1. Gehäusedeckel (1) für eine elektrische Maschine mit einem Gehäuse (11),
wobei der Gehäusedeckel (1) eine äußere Hülle (2) aus thermoplastischem Werkstoff umfasst,
wobei ein innerer Kern (3) aus duroplastischem Werkstoff vorgesehen ist,
wobei in dem inneren Kern (3) eine elektrische Schaltungsanordnung (4) eingebettet ist, welche über ein elektrisches Verbindungselement (6) verbindbar ist, und wobei der Gehäusedeckel (1) derartig geformt ist, dass mit ihm eine stirnseitige Öffnung des Gehäuses (11) der elektrischen Maschine dicht verschließbar ist,
**dadurch gekennzeichnet, dass** auf einer Stirnseite des inneren Kerns (3) ein Lagersitz (8) ausgebildet ist.

2. Gehäusedeckel (1) nach Anspruch 1, **dadurch gekennzeichnet, dass** die elektrische Maschine als ein elektrischer Motor ausgeführt ist und eine Welle (14) des elektrischen Motors in dem Lagersitz (8) gelagert ist.

3. Gehäusedeckel (1) nach Anspruch 2, **dadurch gekennzeichnet, dass** der elektrische Motor als ein Aktuatormotor (23) für eine Allrad-Getriebeanordnung ausgeführt ist.

4. Gehäusedeckel (1) nach Anspruch 1, **dadurch gekennzeichnet, dass** die elektrische Maschine als eine Pumpe ausgeführt ist und eine Pumpenwelle in dem Lagersitz (8) gelagert ist.

5. Gehäusedeckel (1) nach Anspruch 1, **dadurch gekennzeichnet, dass** auf dem Gehäusedeckel (1) zumindest eine Montageeinrichtung (9) ausgebildet ist, über die der Gehäusedeckel (1) mit der elektrischen Maschine verstemmt ist.

6. Gehäusedeckel (1) nach Anspruch 1, **dadurch gekennzeichnet, dass** der Gehäusedeckel (1) mit der elektrischen Maschine verschraubt ist.

7. Gehäusedeckel (1) nach Anspruch 1, **dadurch gekennzeichnet, dass** der Gehäusedeckel (1) über einen Feder-Klick-Verschluss mit der elektrischen Maschine verbunden ist.

## Claims

1. Housing cover (1) for an electric machine with a housing (11),
wherein the housing cover (1) comprises an outer casing (2) made from thermoplastic material,
wherein an inner core (3) made from thermosetting material is provided,
wherein an electric circuit arrangement (4), which can be connected by way of an electrical connecting element (6), is embedded in the inner core (3), and
wherein the housing cover (1) is shaped such that with it a face side opening of the housing (11) of the electric machine can be closed in a tight manner,
**characterised in that** a bearing seat (8) is embodied on a face side of the inner core (3).

2. Housing cover (1) according to claim 1, **characterised in that** the electric machine is designed as an electric motor and a shaft (14) of the electric motor is mounted in the bearing seat (8).

3. Housing cover (1) according to claim 2, **characterised in that** the electric motor is embodied as an actuator motor (23) for an all-wheel gearing arrangement.

4. Housing cover (1) according to claim 1, **characterised in that** the electric machine is designed as a pump and a pump shaft is mounted in the bearing seat (8).

5. Housing cover (1) according to claim 1, **characterised in that** at least one assembly facility (9) is embodied on the housing cover (1), by way of which the housing cover (1) is caulked with the electric machine.

6. Housing cover (1) according to claim 1, **characterised in that** the housing cover (1) is screwed to the electric machine.

7. Housing cover (1) according to claim 1, **characterised in that** the housing cover (1) is connected to the electric machine by way of a spring-click lock mechanism.

## Revendications

1. Couvercle de boîtier (1) pour machine électrique avec un boîtier (11),
dans lequel le couvercle de boîtier (1) comprend une enveloppe externe (2) en matière thermoplastique,
dans lequel est prévu un noyau interne (3) en matière thermodurcissable,
dans lequel dans le noyau interne (3) est inséré un circuit électrique (4), lequel peut être relié par un élément de liaison électrique (6), et dans lequel le couvercle de boîtier (1) est formé de manière telle qu'avec lui peut être obturée de façon étanche une ouverture frontale du boîtier (11) de la machine électrique,
**caractérisé en ce que** sur un côté frontal du noyau interne (3) est conçu un siège de palier (8).

2. Couvercle de boîtier (1) selon la revendication 1, **caractérisé en ce que** la machine électrique est réalisée comme un moteur électrique et **en ce qu'**un arbre (14) du moteur électrique est logé dans le siège de palier (8).

3. Couvercle de boîtier (1) selon la revendication 2, **caractérisé en ce que** le moteur électrique est réalisé comme un moteur d'actionneur (23) pour un dispositif de transmission à quatre roues motrices.

4. Couvercle de boîtier (1) selon la revendication 1, **caractérisé en ce que** la machine électrique est réalisée comme une pompe et un arbre de pompe est logé dans le siège de palier (8).

5. Couvercle de boîtier (1) selon la revendication 1, **caractérisé en ce que** sur le couvercle de boîtier (1) est conçu au moins un dispositif de montage (9) par lequel le couvercle de boîtier (1) est maté avec la machine électrique.

6. Couvercle de boîtier (1) selon la revendication 1, **caractérisé en ce que** le couvercle de boîtier (1) est vissé avec la machine électrique.

7. Couvercle de boîtier (1) selon la revendication 1, **caractérisé en ce que** le couvercle de boîtier (1) est relié à la machine électrique par une fermeture à ressort et à clic.
